# EUROPEAN PATENT SPECIFICATION

(11) **EP 1 012 671 B1**
(45) Date of publication and mention of the grant of the patent: **24.09.2003**
(21) Application number: 99954589.0
(22) Date of filing: 14.07.1999
(51) Int. Cl.: G03F 7/004, G03F 7/027, G02B 5/20, G03F 7/00, G02F 1/1335

(54) **PHOTOSENSITIVE BLACK MATRIX COMPOSITION AND PROCESS OF MAKING IT**
FOTOEMPFINDLICHE ZUSAMMENSETZUNG FÜR SCHWARZMATRIX UND VERFAHREN ZUR HERSTELLUNG DER ZUSAMMENSETZUNG
COMPOSITION POUR MATRICE NOIRE PHOTOSENSIBLE ET SON PROCEDE DE FABRICATION

(30) Priority: 14.07.1998 US 115142
(43) Date of publication of application: 28.06.2000
(73) Proprietor: Brewer Science, Inc., Rolla, Missouri 65401 (US); Nissan Chemical Industries Ltd., Chiyoda-ku, Tokyo 101 (JP)
(72) Inventor: SABNIS, Ram, W., Rolla, MO 65401 (US); MAYO, Jonathan, W., Rolla, MO 65401 (US); BREWER, Terry, L., Rolla, MO 65401 (US); STRODER, Michael, D., Springfield, MO 65809 (US); EMA, Kiyomi, Chiba-shi, Chiba 284 (JP); SONE, Yasuhisa, Funabashi-shi, Chiba 274 (JP); NIHIRA, Takayasu, Tokyo 134 (JP); AOBA, Kazuhiro, Narashino-shi, Chiba 275 (JP); YANAGIMOTO, Akira, Musashino-shi, Tokyo 180 (JP)
(74) Representative: Brookes Batchellor
(86) International application number: US9915904
(87) International publication number: WO00004421

(56) References cited:
- JP-A- 8 034 923
- JP-A- 9 054 431
- US-A- 5 176 971
- US-A- 5 489 621
- US-A- 5 593 802

## Description

### FIELD OF THE INVENTION

The present invention relates to black matrix coating compositions, and particularly those which, after deposition, can be photolithographically patterned at high resolution.

### BACKGROUND OF THE INVENTION

Flat panel displays use an optically opaque black matrix structure around the light-emitting elements to improve display contrast. Display manufacturers have relied primarily on vacuum-deposited chrome/chrome oxide materials for forming thin (< 1 µm) black matrix structures with high optical density (> 3) and high volume resistivity (> 10⁸ ohm-cm). Such processes are described, for example, in U.S. Patents 5,378,274 to Yokoyama et al.; 5,587,818 to S. Lee; and 5,592,317 to Fujikawa et al. However, there is a strong desire on the part of the industry to replace chromium-based materials with lower cost, easily patternable organic black matrix coatings which, unlike chromium materials, pose little or no threat to the environment.

A host of organic black matrix materials have been demonstrated over the past ten years. Latham et al, in U.S. Patent 4,822,718 and Shimamura et al. in U.S. Patent 5,176,971 disclosed dyed black matrix compositions containing a polyimide precursor binder. However, these compositions suffered from certain drawbacks, e.g., short storage life, relatively low optical density (after deposition), poor thermal stability, and fading resistance. The dye based compositions were also prone to dye leaching from the composition during subsequent processing steps. The coatings were not inherently photoimageable, and therefore could not be patterned without a separate photoresist layer.

A variety of pigment-dispersed (as distinguished from "dye-based") black matrix coating systems were developed to achieve higher optical density, improved thermal stability, and greater resistance to both fading and chemical attack. None of these compositions met the full requirements for a thin, high optical density black matrix system with high electrical resistivity. The various systems are discussed below.

U.S. Patent 5,251,071 to Kusukawa et al. described black-pigmented polyimide precursor compositions. Though improved thermal stability and optical density of the black matrix was achieved over dyed systems, the compositions required separate application of a photoresist for patterning and had short shelf lives stemming from the use of the polyimide precursor binder.

Photosensitive, carbon black filled compositions were developed to simplify black matrix deposition and further increase optical density. For example, Hesler et al., in the article "Pigment-dispersed organic black matrix photoresists for LCD color filters" (SID Digest, vol. 26, p. 446, 1995), disclosed that carbon black dispersed in a photosensitive acrylic polymer provided an average optical density of 2.8 for a film thickness of 1.5 µm, however, the composition showed poor coating properties and poor image quality. Similar results were reported by Hasumi et al. in the article, "Carbon dispersed organic black matrix on thin film transistor", (Proc. of Int. Display Res. Conf. (EuroDisplay-96), vol. 16, p. 237, 1996).

U.S. Patent 5,718,746 by Nagasawa et al. also disclosed carbon black filled compositions. Nagasawa therein reported that if the pigment concentration exceeded 30% in the coating, the stability of the dispersion was poor. Also, the high conductivity of the high carbon black loading in the coating was desirable for Nagasawa's purposes.

The use of carbon black to obtain high optical density in thin films invariably creates a trade-off with black matrix resistivity. Accordingly these materials have found acceptable utility only where carbon black's conductivity can be tolerated. Our co-pending U.S. patent application, Serial No. 08/982233, for example, describes an improved carbon black filled coating for use in such situations.

Japanese Patent application 9-166869 (unexamined) by Tokyo Ohka Kogyo Co., Ltd. describes a black matrix composition where carbon black pigment particles are coated with a polymer layer to reduce their conductivity. This coated carbon black is then dispersed in a photoresist resin system to form the black matrix composition. Although the cured coatings show high resistivity, the optical density is only about half of what is required for a chrome black matrix replacement.

Photosensitive black matrix coating compositions comprising nonconductive organic and inorganic pigments, sometimes in admixture with carbon black, have been developed recently to simultaneously achieve medium optical density, easy patternability, and high volume resistivity at film thicknesses of 1.5-2.0 microns. For example, U.S. Patent 5,368,976 by Tajima et al. discloses pigment-dispersed color filter compositions useful for the production of LCD and charged coupled devices. The molecular weight of the copolymer binder has to be carefully controlled to obtain good image quality. Japanese Patent application 8-34923 (unexamined) by Sekisui Chemical Industries, Ltd. discloses a two-step black matrix process wherein a photosensitive, pigmented black layer is deposited on the substrate, patterned, and then further colored by diffusing a black dye into the patterns. This process is too cumbersome for commercial use. Japanese Patent application 8-36257 (unexamined) by Sekisui Chemical Industries, Ltd. describes black matrix coating compositions which use silica-coated metal oxide pigments to reduce the conductivity of the pigment particles. They claim to achieve resistivities greater than 10⁶ ohm-cm. However resistivity of 10⁸ ohm-cm is necessary to fulfill the requirements for a chrome black matrix replacement, therefore it is doubtful these compositions can be used at ≼ 1 micron film thicknesses. Related compositions with improved shelf life are described, for example, in U.S. Patents 5,626,796 to Tsujimura et al.; 5,639,579 to Hayashi et al.; and 5,714,286 to Uchikawa et al. However, none of these shelf life-improved compositions exhibit the high optical density which is achieved by chrome black matrix systems. Therefore, the pigment dispersed systems, until now, have not met the more demanding requirements for black matrix systems which chrome seems to satisfy.

Titanium black, a metal oxide pigment, is treated with an organosilane or reactive silicone agent to reduce its conductivity in the black matrix coating composition disclosed in Japanese Patent application 9-54431 (unexamined) by Nippon Kayaku Co.1, Ltd. However resistivity of this composition is 10⁵ ohm-cm which is not a high enough resistivity to fulfill the requirements for chrome black matrix compositions.

An easily applied, photodefinable organic black matrix coating complete with other critical performance characteristics would represent a welcomed advancement in the art and satisfy a long felt need.

### SUMMARY OF INVENTION

The principal object of the present invention is to provide an improved photodefinable black matrix coating which negates the need for a photoresist and which exhibits high optical density and high volume resistivity when applied at film thicknesses of 1 micron.

A second object of the present invention is to provide improved processes for making and using the above-described coating composition to construct flat panel displays and other optoelectronic devices requiring light-blocking layers.

A further object of the present invention is to provide a more environmentally acceptable yet more efficient black matrix system than chrome/chrome oxide.

We have discovered that these objectives are met by a black matrix coating as defined in annexed Claim 1

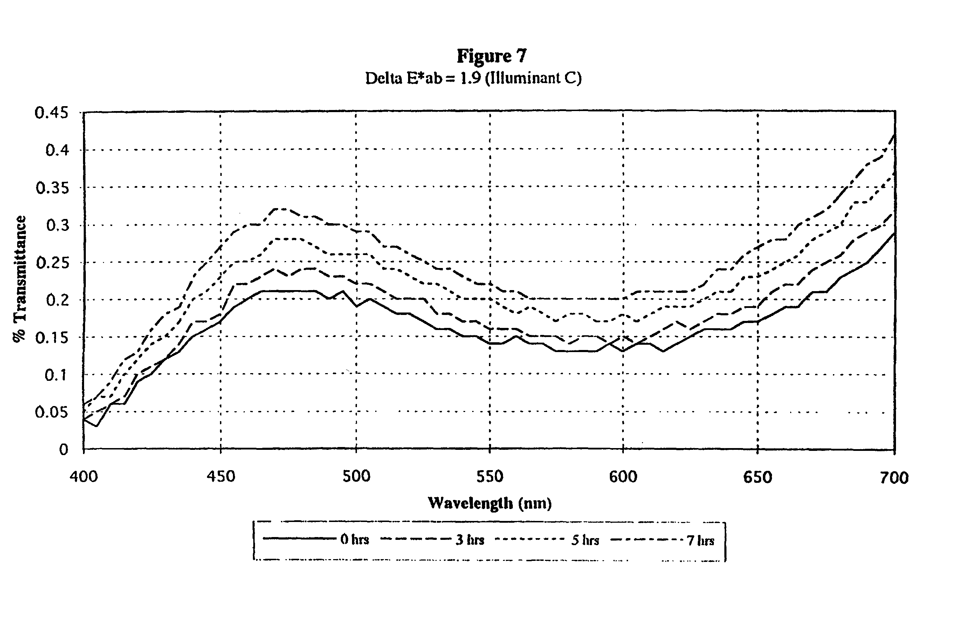

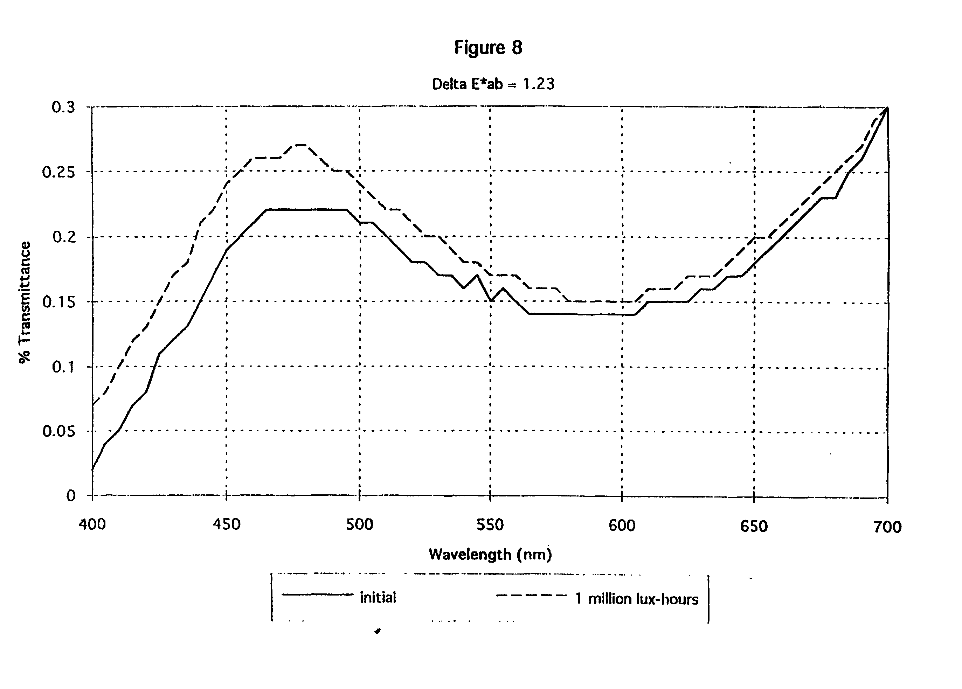

The organic black matrix of the present invention generally is characterized by the following performance properties:
1. optical density ≥ ∼ 3 across the 400-700 nm optical wavelength region when applied at film thicknesses of ≤ 1 µm;
2. high volume resistivity, > 10⁸ ohm-cm;
3. excellent coating quality; that is having no particles or pinholes observable by light microscopy;
4. adequate shelf life (of 3 months under refrigeration and > 1 week at room temperature);
5. high thermal stability, AE_{ab} < 3 after heating at 230 C for 7 hrs in air (See FIG. 7);
6. high fading resistance, AE_{ab} < 3 after 10⁸ lux-hrs illumination with simulated solar radiation (See FIG 8);
7. photodefinable characteristics without the need for a separate photoresist material.

### BRIEF DESCRIPTION OF THE DRAWINGS

FIG. 1 is a flow chart explaining the method of use for the black matrix coating composition of the present invention.
FIG. 2 is the optical transmission spectra of a 1 µm-thick cured film of the coating composition prepared in Example 1.

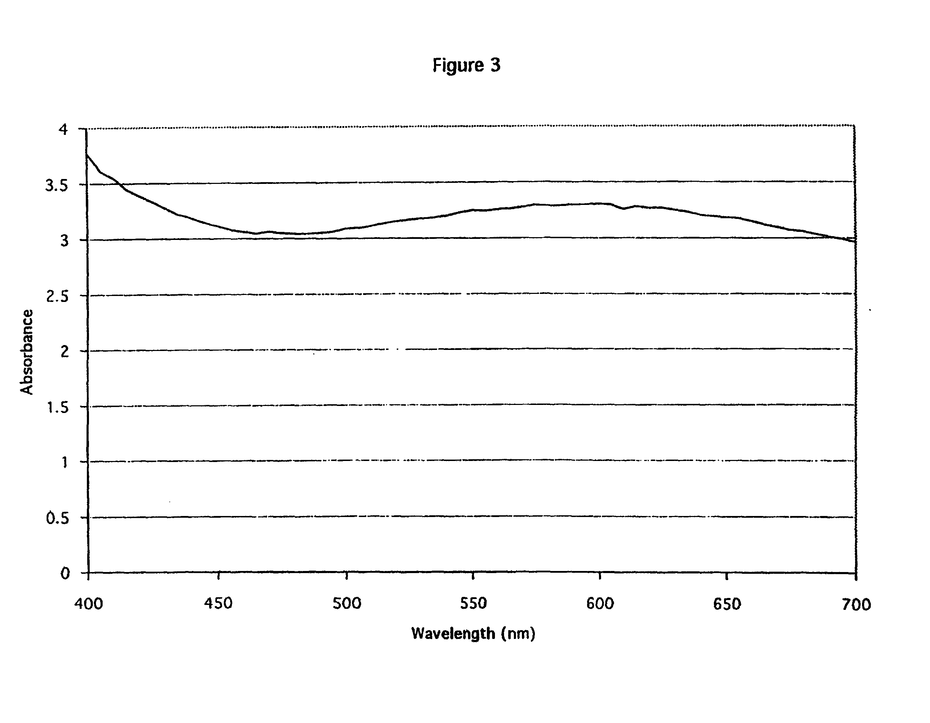

FIG. 3 is a graph showing the optical absorbance spectra of a 1 µm-thick cured film of the coating composition prepared in Example 1, where optical density is defined as the absorbance (A) of the coating layer at 540 nm.
FIG. 4 is a photomicrograph of a resolution dagger feature on the test mask used to evaluate the lithographic properties of the black matrix coating of Example 1.
FIG. 5 is a scanning electron microphotograph of the surface of a cured film of the coating composition prepared in Example 1.
FIG. 6 is a graph illustrating the typical surface roughness of a cured film of the coating composition prepared in Example 1.
FIG. 7 shows the change in percent transmittance across the visible spectrum for a one micron-thick coating of the Example 1 composition when it was baked at 230°C for increasing amounts of time. The AE_{ab} (thermal stability) calculated from the spectral data after 7 hours baking was 1.9.
FIG. 8 shows the change in percent transmittance across the visible spectrum for a one micron-thick coating of the Example 1 composition when it was exposed to artificial solar radiation at a cumulative dosage of one million lux-hrs. The AE_{ab} (fading resistance) calculated from the spectral data was 1.23.

### DETAILED DESCRIPTION OF THE INVENTION

The improved black matrix coatings of this invention formulated at 20-50 wt. % total solids, in solution, having volume resistivity greater than 10⁸ ohm-cm and optical density greater than 3.0 at film thicknesses of 1 µm or less, comprising:
a. a binder system consisting of:
   1) an alkali-soluble polymer binder and
   2) a photopolymerizable polyfunctional acrylate or methacrylate co-monomer or mixture of co-monomers, with each co-monomer having one or more ethylenically unsaturated double bonds per molecule;
b. a silica-coated metal oxide pigment or pigments having a primary particle size of 0.01- 0.02 µm, at least 50 wt. % of the particles having a primary particle size smaller than 0.02 µm;
c. a trialkoxyorganosilane coupling agent or admixtures thereof;
d. a free-radical generating photoinitiator or photoinitiator system or admixtures thereof, operatable at less than 400 nm exposing wavelengths;
e. a solvent vehicle selected from alcohols, esters, glymes, ethers, glycol ether, ketones, dialkylamides, lactams, lactones and their admixtures; and
f. a solvent soluble organic dye at levels of less than 3 wt. % of the weight of added pigment solids; whereby the composition has substantially improved shelf life compare to other photoimageble organic black matrices having high optical density and low conductivity.

### COMPONENTS OF THE COMPOSITION

### a. Binder System

The alkali-soluble polymer binder is preferably a vinyl polymer or copolymer containing acrylic or methacrylic acid or other ethylenically unsaturated monomers having carboxylic acid, sulfonic acid, sulfonamide, phenolic, or other functional groups which are capable of conferring solubility in aqueous bases to the binder. Especially preferred polymer binders are copolymers formulated from (a.) one or more of the above-described acidic monomers, particularly the methacrylic acid or acrylic acid monomer and (b.) one or more non-acidic (meth) acrylic monomers.

The desired level of acidic monomer in the especially preferred copolymer binder is an amount which effectively allows residue-free wet etching of the overall black matrix composition in traditional alkaline developer solutions during photoimaging, i.e. patterning. Our especially preferred polymer binder of this type, for use in the present invention, is a copolymer comprising about 70 mole % benzyl methacrylate and about 30% methacrylic acid.

The acrylic co-monomer component of the binder system will have at least one ethylenically unsaturated double bond capable of free radical-initiated photopolymerization which facilitates highly effective patterning. The use of a co-monomer or a mixture of co-monomers having two or more ethylenically unsaturated double bonds per molecule is even more preferred for purposes of obtaining high photospeed and good resolution. Examples of suitable co-monomers include widely-known (meth) acrylate esters such as 2-hydroxyethyl (meth) acrylate, hydroxypropyl methacrylate, benzyl methacrylate, isobutyl (meth) acrylate, and phenyl (meth) acrylate. Also suitable are ethylene glycol dimethacrylate, pentaerythritol triacrylate and tetraacrylate; dipentaerythritol pentaacrylate and hexaacrylate; polyester (meth)acrylates obtained by reacting (meth) acrylic acid with polyester prepolymers; urethane (meth)acrylates; epoxy (meth)acrylates prepared by reacting (meth)acrylic acid with epoxy resins such as bisphenol-A type resins, bisphenol-F type epoxy resins, and novolak-type epoxy resins; and tris(2-acryloyloxyethyl) isocyanurate. Of these, polyfunctional acrylate monomers such as pentaerythritol tetraacrylate, dipentaerythritol pentaacrylate, and dipentaerythritol hexaacrylate are preferred for use in the present invention. The use of pentaerythritol tetraacrylate is especially preferred.

The preferred molecular weight range of the acrylic polymer binder is 25,000 - 150,000 weight average molecular weight. Most preferred is 50,000 - 120,000 weight average molecular weight.

### b. Silica-Coated Metal Oxide Pigments

Silica-coated pigments comprised of single or mixed metal oxides of copper, manganese, cobalt, nickel, chromium and iron are preferred or use in the present invention because they impart high optical density and high resistivity to the final black matrix structure and show superior dispersibility when further treated with silane coupling agents. Suitable pigments include, for example, Pigment Black 22 (C.I. 77429), Pigment Black 26 (C.I. 77494), Pigment Black 27 (C.I. 77502), and Pigment Black 28 (C.I. 77428). The pigments may be used singly or in admixture, including admixtures with organic pigments. The use of Pigment Black 26 (for example, Daipyroxide® Black-3551 obtained from Dainichiseika Color & Chemicals Mfg. Co. Ltd., Japan), which is a silica-coated mixed metal oxide of copper, manganese, and iron, is especially preferred for obtaining a black matrix structure with high optical density and low surface conductivity.

The silica coating of the pigment particles preferably should comprise 0.5-5% of total pigment weight, and more preferably 1-3% of pigment weight.

The silica-coated pigment should have particle sizes sufficient to allow filtration at resolutions smaller than 1 micron. For example, a primary particle size of 0.01-0.02 µm for the preferred silica-coated metal oxide pigments works well, especially when at least 50 wt.% of the particles have a primary particle size smaller than 0.02 µm.

### c. Silane Coupling Agents

Trialkoxyorganosilane coupling agents are present in the improved black matrix coating compositions to improve the dispersibility of the silica-coated pigments in organic media, increase their compatibility with and wettability by the organic components of the coatings, and enhance the overall adhesion of the coating to the display substrate. The structure of the coupling agents can be represented generally as:

**(R'O)**_{**3**}**-Si-R"**

where R' is typically methyl or ethyl and R" is a nonhydrolyzable radical that possesses a functionality which enables the coupling agent to bond, either physically or chemically, with the organic components of the coating. It is assumed that the trialkoxysilane function of the coupling agent forms chemical bonds with hydroxyl groups on the surface of the silica-coated pigments, leaving the more hydrophobic R" groups to interact with the solvent and binder components. Coupling agent molecules may additionally condense into surface-bound polymeric layers.

Examples of trialkoxyorganosilane coupling agents which may be used suitably in the present invention include methyl trimethoxysilane, n-butyl trimethoxysilane, 3-chloropropyl-trimethoxysilane, ethyl trimethoxysilane, n-propyl trimethoxysilane, phenyl trimethoxysilane, 3-(trimethoxysilyl) propyl methacrylate, 3-glycidoxypropyltrimethoxysilane, vinyl trimethoxysilane, n-octadecyl triethoxysilane, amyl triethoxysilane, chloromethyl triethoxysilane, chlorophenyl triethoxysilane, benzyl triethoxysilane, n-octyl triethoxysilane, phenyl triethoxysilane, vinyl triethoxysilane, vinyl triphenoxysilane, and n-octadecyl triethoxysilane. The coupling agents may be used singly or in admixture and are typically added at about 5 wt.% based on pigment solids. The use of methyl trimethoxysilane is highly preferred for obtaining good dispersion stability and pigment wetting.

### d. Photopolymerization Initiators or Initiator Systems

All known free radical initiators or initiator systems which operate effectively at < 400 nm exposing wavelengths can be substantially employed as the photopolymerization initiator or initiator system for the present invention. Examples thereof include:
1) trihalomethyl-substituted triazines such as p-methoxy-phenyl-2,4-bis(trichloromethyl)-s-triazine;
2) trihalomethyl-substituted oxadiazoles such as 2-(p-butoxy-styryl)-5-trichloromethyl-1,3,4-oxadiazole;
3) imidazole derivatives such as 2-(2'-chlorophenyl)-4, 5-diphenylimidazole dimer (with a proton donor such as mercaptobenzimidazole);
4) hexaaryl biimidazoles such as 2,2'-bis(o-chlorophenyl)-4,4',5,5'-tetraphenylbiimidazole;
5) benzoin alkyl ethers such as benzoin isopropyl ether;
6) anthraquinone derivatives such as 2-ethylanthraquinone;
7) benzanthrones;
8) benzophenones such as Michler's ketone;
9) acetophenones such as 2,2-diethoxy-2-phenylacetophenone and 2-benzyl-2-N,N-dimethylamino-1-(4-morpholinophenyl)-1-butanone;
10) thioxanthones such as 2-isopropylthioxanthone;
11) benzoic acid ester derivatives such as octyl p-dimethyl-aminobenzoate;
12) acridines such as 9-phenylacridine;
13) phenazines such as 9,10-dimethylbenzphenazine; and,
14) titanium derivatives such as bis(cyclopentadienyl)-bis (2, 6-difluoro-3-(pyl-1-yl)titanium.

Photopolymerization initiators may be used alone or in admixture, for example, by combining 2-isopropylthioxanthone with octyl p-dimethylaminobenzoate (ODAB). The use of amine-substituted acetophenones such as
2-benzyl-2-N,N-dimethylamino-1-(4-morpholino-phenyl)-1-butanone(IR GACURE 369® Ciba Geigy Corporation) in combination with thioxanthone-ODAB mixtures are preferred for obtaining high photospeed and sharp imaging properties.

### e. Solvent Vehicle

Suitable solvents for the improved black matrix compositions are alcohols, esters, glymes, ethers, glycol ether, ketones, dialkylamides, lactams, lactones and their admixtures. Examples of useful solvents include N-methyl-2-pyrrolidone (MMP), dimethylacetamide (DMAc), dimethylformamide (DMF), cyclohexanone, bis-2-methylethyl ether diglyme), tetrahydrofurfuyl alcohol (THFA), dimethylsulfoxide DMSO), xylenes, 2-heptanone, ethyl lactate, ethyl 3-ethoxypropionate, methyl 3-methoxypropionate, propylene glycol methyl ether acetate. The use of mixtures of MMP and cyclohexanone are especially preferred for obtaining good coating quality and long storage life.

### f. Solvent-soluble Organic Dyes

Solvent-soluble organic dyes are added in small proportions to the improved black matrix composition to critically enhance coating properties such as coating quality and shelf life. The addition of selected dyes significantly reduces the occurrence of particulates, voids, pinholes, and striations in the coated composition and extends room temperature shelf life of the coating formulation from typically a few hours to 5-10 days. Dye addition may also provide marginal improvements in coating optical density and volume resistivity.

The chemical nature of the dye is critical for achieving the desired improvements. For example, preferred azo-1,2-chrome complex dyes such as Solvent Black 28, Solvent Black 27, Solvent Black 29, and Solvent Black 45 significantly enhance coating quality and shelf life, whereas solvent-soluble dyes from other classes generally give no improvement or actually diminish coating properties. Examples of poorly performing dyes include Solvent Black 35, Solvent Brown 44, Solvent Blue 67, Solvent Black 3, Solvent Black 5, Solvent Black 7, Solvent Black 46, and Solvent Black 47. Within the azo-1,2-chrome complex dye class, Solvent Black 28 is the most preferred because it not only improves shelf life and coating quality, but enables high resolution (3 µm) patterning of black matrix features with sharply vertical side walls.

The amount of dye is also critical for obtaining the desired enhancements in coating performance and stability. The solvent-soluble dyes are preferably used at 0.2-3.0 wt.% based on the weight of added pigment(s), and more preferably at 1.0-2.0 wt.% based on pigment weight. If more than 5 wt.% is used, the coating will develop too rapidly, reducing pattern resolution or causing the formation of residues during development.

### PREFERRED COMPOSITIONAL RANGES

The improved black matrix coating compositions are preferably formulated at 20-50 wt.% total solids in solution to obtain coatings having a layer thickness of 1-2 µm after application and curing. A coating solids level of 30-40 wt.% is especially preferred for obtaining good quality spin coatings with layer thicknesses of about one micron.
The chart below gives the preferred and most preferred loadings (expressed as wt.% of total coating solids) for each major component in the coatings.

| Component | Preferred Wt.% of Coating Solids | Most Preferred Wt.% of Coating Solids |
|---|---|---|
| polymer binder | 5-15 | 8-12 |
| polyfunctional co-monomer(s) | 2-7 | 3-5 |
| pigment(s) | 40-70 | 50-60 |
| trialkoxyorganosilane | 1-5 | 2-4 |
| photoinitiator(s) | 10-40 | 20-30 |
| solvent-soluble dye(s) | 0.2-3.0* | 1.0-2.0* |

| | | |
|---|---|---|
| *(based on dry pigment solids) | | |

The desired range of silane coupling agent to solvent-soluble dye(s) is 10/1-1/4 by weight; preferably
5/1-1/2 by weight, and most preferably 5/1 by weight.

### METHOD OF USE

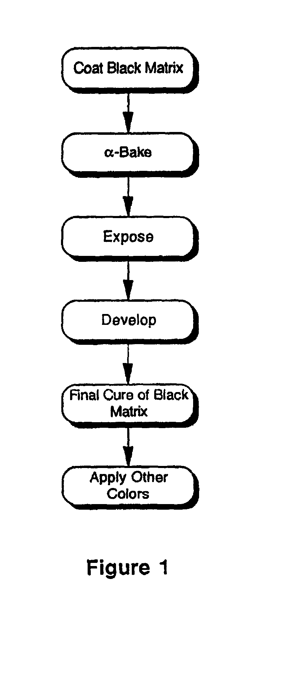

The improved black matrix coating compositions are applied, patterned, and cured in a photolithographic process to obtain thermally stable black matrix structures exhibiting high optical density and electrical resistivity. The deposition process may be summarized as follows (Figure 1). The display substrate, typically glass, is cleaned. The black matrix coating is spin coated onto the glass substrate at 1000-1200 rpm for 90 seconds and then α-baked on a hot plate at 100°C for 60 seconds to obtain a uniform layer which is approximately one micron in thickness. The coating is exposed at 200-2000 mJ/cm², preferably at 500-1200 mJ/cm² through a negative-tone mask using a mid-ultraviolet light source to form a latent image in the black matrix layer. It is then developed in a potassium carbonate solution for 30 seconds, spray rinsed for 10 seconds, and spun dry to etch away the non-light-struck areas in the layer. Finally, the patterned black matrix coating is cured at 230°C in a convection oven for 1 hour to make it fully resistant to subsequently applied coating layers during the formation of flat panel displays and other optoelectronic devices which require light-blocking layers.

### EXAMPLES

The following examples illustrate the process and product of the present invention. The intermediate pigment dispersions were prepared in a Eiger MINI-100 motormill using 0.5 mm glass beads as the grinding media. The process described in Example 1 was used to prepare all of the examples. A different dye was used for each example.

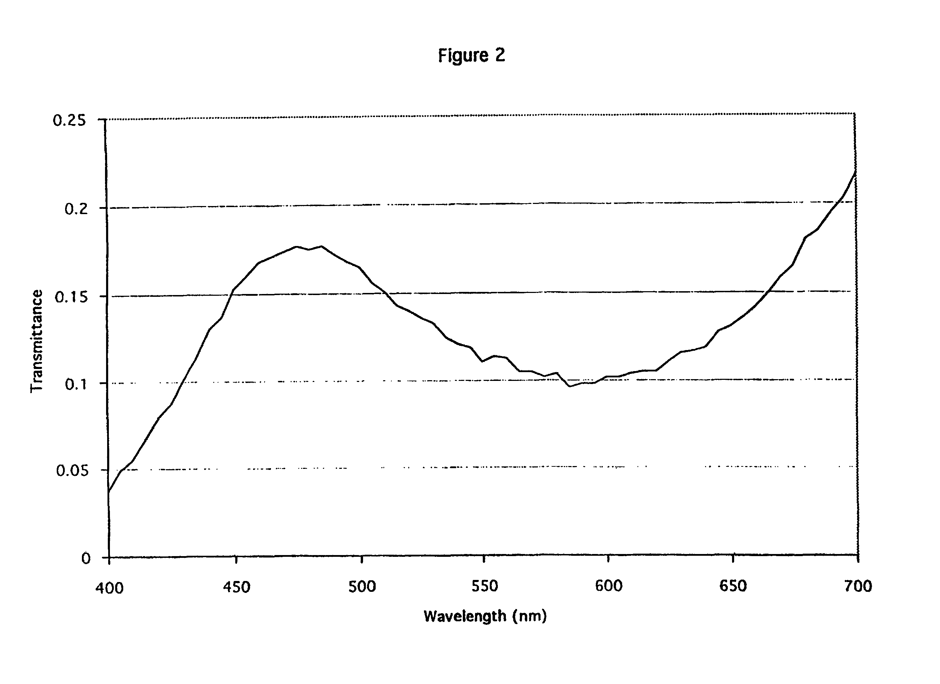

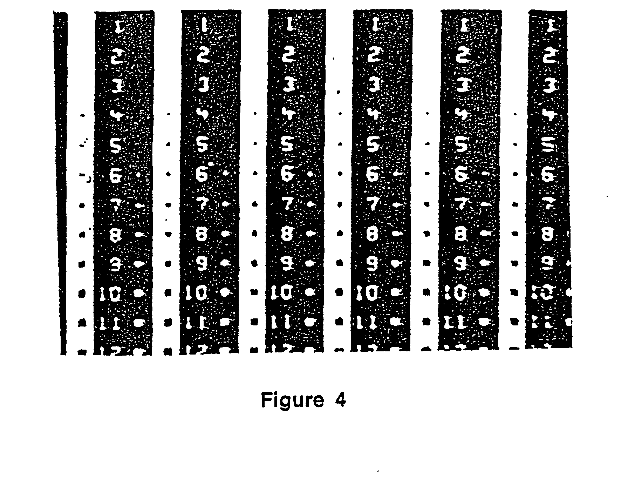

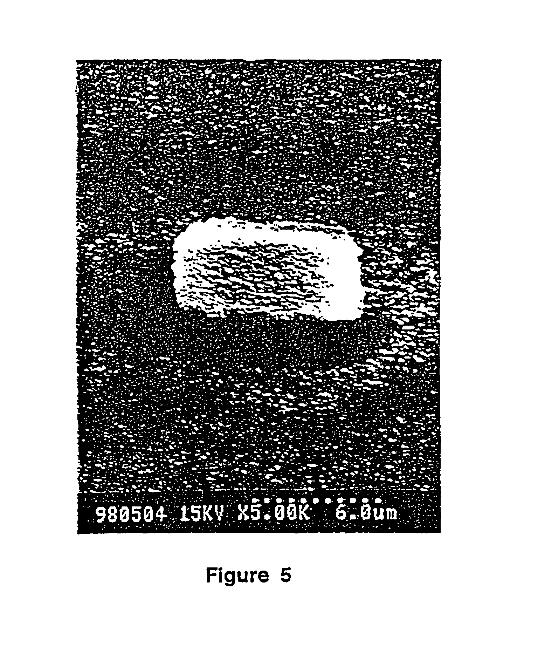

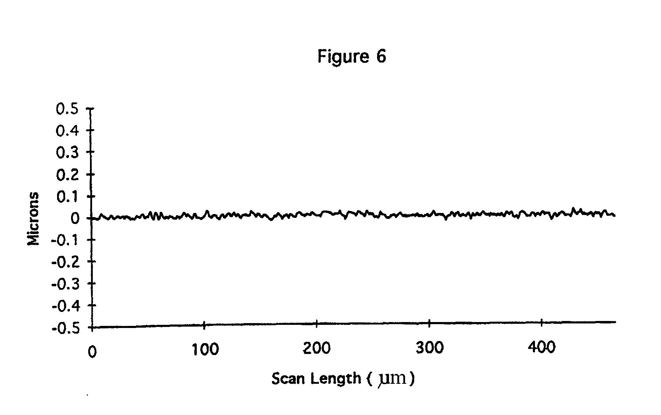

The Example 1 composition, which used the dye Solvent Black 28 was free of particles, voids, and pinholes, and striations showed low surface roughness (Figures 5 & 6). The addition of Solvent Black 28 also increased the shelf life of the composition to from less than one day to about 5-10 days while enabling the highest resolution patterning. The patterns were residue-free and had sharp vertical side walls (Figure 4). Transmittance values for black matrix coatings should be below 1.0% across the wavelength range, 400-700nm. Figure 2 shows the transmittance for the black matrix coating composition of Example 1 to be well below this value. The optical density of the coating in Example 1 is 3.1, where optical density is defined as the absorbance of the coating layer at 540 nm
(Figure 3).

The use of the non-preferred Solvent Black 35 in Example 7 resulted in poor quality coatings with many particles and pinholes.
This indicates the importance of using the correct dye in obtaining superior results. See Table 1.

| EXAMPLE # | DYE Color Index Name | OD@ 1µm | REFLECTANCE % | SURFACE µm | VOLUME RESISTIVITY Ωcm |
|---|---|---|---|---|---|
| EXAMPLE 1 | Orasol Black CN Solvent Black 28 | 3.1 | 2.1 | 0.05 | 3.4 X 10⁹ |
| EXAMPLE 2 | Orasol Black RLI Solvent Black 29 | 3.5 | 2.0 | 0.04 | 7.0 X 10⁹ |
| EXAMPLE 3 | Neopen Black X53 Solvent Black 27 | 3.4 | 1.8 | 0.06 | 5.9 X 10⁹ |
| EXAMPLE 4 | Zapon Black X 51 Zapon Black 1.9 X 10⁹ Solvent Black 27 | 3.1 | 3.1 | 0.03 | 1.9 X 10⁹ |
| EXAMPLE 5 | Savinyl Black RLS Solvent Black 45 | 3.1 | 2.9 | 0.05 | 5.7 X 10⁹ |

### EXAMPLE 1

Preparation of Intermediate Pigment Dispersion. Into a plastic beaker was added 20g of N-methylprrolidone (NMP), 111g of cyclohexanone, 3.12g of methyl trimethoxysilane, 62.4g of Pigment Black 26 (silica-coated) and 20g of polymer binder solution. The latter was a 25 wt.% NMP solution of an acrylic copolymer comprising 70 mole % benzyl methacrylate and 30 mole % methacrylic acid.) The mixture was stirred with a spatula for about 5 minutes until it became homogenous. This pigment slurry was then introduced into the grinding mill turning at 1000 rpm over a period of 15 minutes. The contents were rinsed into the mill with 10g of NMP. The grind speed was slowly increased to 3000 rpm. The pigment was then ground at this speed for 2 hours.

In a separate plastic breaker was added 20g of polymer binder solution and 0.62g of ORASOL Black CN (® Ciba-Geigy Corporation, aka Solvent Black 28, 1 wt.% based on silica-coated pigment). The mixture was stirred for 10 minutes and then added to the contents of the mill after they had been grinding for 2 hours. The dye solution was rinsed into the mill with 34.2g of fresh NMP. The mill contents were then further ground at 3000 rpm for 90 minutes. The pigment dispersion was discharged from the mill and filtered through 0.2 µm pore size filters.

Preparation of Black Matrix Coating Formation. 30g of the above pigment dispersion, 0.5g of pentaerythritol tetraacrylate, 0.6g of isopropylthioxanthone, 1.2g of octyl-p-dimethylamino-benzoate, and 1.2g IRGACURE 369 were combined by stirring under yellow light for 15 minutes. The resulting product composition was filtered through a 0.2 µm pore size filter. Shelf life of the black matrix is more than 3 months under refrigeration.

### Applying the Black Matrix

The black matrix was spincoated on glass substrate at 1 µm film thickness and prebaked on a hot plate at 100°C for 1 min. The black matrix is photosensitive and does not require a photoresist coating. The black matrix was exposed with a high pressure mercury lamp at 500-1000 mJ/cm², developed in dilute alkaline developer for 30 sec, rinsed in DI water for 30 sec. The resulting image was final cured in a convection oven at 230°C for 1 hour. Resolution in the range of 3-6 µm was achieved. Volume resistivity measurements made in accordance with ASTM D257 methods for a 1 µm film were on the order of 10⁹-10¹¹ Ω-cm. Reflectance of the 1 µm black matrix after final cure was 2.1%. Surface roughness was in the range of 0.03-0.05 µm.

### Thermal stability

The black matrix must exhibit high thermal stability during the alignment layer formation step. Figure 7 shows the spectral change at 1µm film thickness before and after heating. The chromatic changes (ΔE*ab) are less than 3 (ΔE*ab=1.9) after heating in a convection oven at 230°C in air for 7 hours, thus showing excellent thermal stability.

### Light Resistance

The light resistance of pixels is important because these pixels are illuminated with back light of LCDs. The black matrix was exposed to a Mercury-Xenon lamp (200-1300 lux) with a UV filter. Figure 8 shows the spectral changes of the black matrix after 1 million lux hours. The chromatic changes (ΔE*ab) are less than 3 (ΔE*ab = 1.2), demonstrating the superior light resistance of the black matrix.

### Chemical Resistance

**Table 2**

| Chemicals | Chromatic changes after dipping for 1 min (ΔE*ab) |
|---|---|
| HMP | 0.40 |
| Ethanol | 0.46 |
| Acetone | 0.13 |
| g-Butyrolactone | 0.68 |
| Isopropanol | 0.65 |
| Cyclohexanone | 0.27 |
| PGMEA | 0.37 |
| 5% HCl | 1.06 |
| 5% Na₂C0₃ | 1.31 |
| 5% TMAH | 1.24 |

Since color filters are exposed to solvents, acids and bases during the LCD fabrication process, the chemical stability is a key factor. The cured film must be resistant to alignment layer solvents such as NMP and g-butyrolactone, towards acids during etching of the indium tin oxide (ITO) or towards bases used in the development system. The chemical stability of black resist was evaluated by both pattern observation and chromatic changes. After dipping the pixels in solvents, acids and alkaline solution for 1 min, patterns were found to be stable and neither swelling nor peeling was observed. The chromatic changes (ΔE*ab) are less than 3, indicating very good chemical stability of the black matrix (Table 2).

### EXAMPLE 2

A black matrix coating composition of the present invention was prepared identically to that in Example 1 except that ZAPON Black X51 (®BASF Corporation, aka Solvent Black 27/Cation 1, 1 wt.% based on silica-coated pigment) was used in place of ORASOL Black CN.

### EXAMPLE 3

A black matrix coating composition of the present invention was prepared identically to that in Example 1 except that ORASOL Black RLI (®Ciba-Geigy Corporation, aka Solvent Black 29) was used in place of ORASOL Black CN.

### EXAMPLE 4

A black matrix coating composition of the present invention was prepared identically to that in Example 1 except that NEOPON Black X53 (®BASF Corporation, aka solvent Black 27/Cation 2) was used in place of 0.6g of ORASOL Black CN (1 wt.% based on silicia-coated pigment).

### EXAMPLE 5

A black matrix coating composition of the present invention was prepared identically to that in Example 1 except that 1.2g of SAVINYL Black RLS (®Clariant Corporation, aka Solvent Black 45, 2 wt.% based on silica-coated pigment) was used in place of 0.62 g of ORASOL Black CN.

### EXAMPLE 6

A black matrix coating composition of the present invention was prepared identically to that in Example 1 except that no dye was used.

### EXAMPLE 7

A black matrix coating composition of the present invention was prepared identically to that in Example 1 except that Solvent Black 35 was used in place of Solvent Black 28.

## Claims

1. A photosensitive black matrix composition formulated at 20-50 wt. % total solids, in solution, having volume resistivity greater than 10⁸ ohm-cm and optical density greater than 3.0 at film thicknesses of 1 µm or less, comprising:
a. a binder system consisting of:
1) an alkali-soluble polymer binder and
2) a photopolymerizable polyfunctional acrylate or methacrylate co-monomer or mixture of co-monomers, with each co-monomer having one or more ethylenically unsaturated double bonds per molecule;
b. a silica-coated metal oxide pigment or pigments having a primary particle size of 0.01 - 0.02 µm, at least 50 wt. % of the particles having a primary particle size smaller than 0.02 µm;
c. a trialkoxyorganosilane coupling agent or admixtures thereof;
d. a free-radical generating photoinitiator or photoinitiator system or admixtures thereof, operatable at less than 400 nm exposing wavelengths;
e. a solvent vehicle selected from alcohols, esters, glymes, ethers, glycol ether, ketones, dialkylamides, lactams, lactones and their admixtures; and
f. a solvent soluble organic dye at levels of less than 3 wt. % of the weight of added pigment solids; whereby the composition has substantially improved shelf life compare to other photoimageble organic black matrices having high optical density and low conductivity.

2. The black matrix composition of Claim 1, wherein the alkali-soluble polymer binder is a vinyl polymer or copolymer containing acrylic acid, methacrylic acid, or other ethylenically unsaturated monomers having carboxylic acid, sulfonic acid, sulfonamide, phenolic, or other acidic functional groups capable of conferring solubility in aqueous bases to the binder.

3. The black matrix composition of Claim 2, wherein the alkali-soluble polymer binder further contains a non-acidic (meth)acrylic monomer.

4. The black matrix composition of Claim 3, wherein the alkali-soluble polymer binder is a copolymer of methacrylic acid or acrylic acid and one or more non-acidic (meth) acrylic monomers.

5. The black matrix composition of Claim 3, wherein the alkali-soluble polymer binder is a copolymer comprising about 70 mole % benzyl methacrylate and about 30 mole % methacrylic acid.

6. The black matrix composition of Claim i, wherein the co-monomer is a polyfunctional (meth) acrylic co-monomer or mixture of co-monomers having two or more ethylenically unsaturated double bonds per molecule.

7. The black matrix composition of Claim 5, wherein the co-monomer or mixture of co-monomers consists of a polyfunctional acrylate monomer.

8. The black matrix composition of Claim 6, wherein the polyfunctional acrylate monomer is pentaerythritol tetraacrylate.

9. The black matrix composition of Claim 1, wherein the silica-coated metal oxide pigment or pigments are chosen from the group consisting of copper, manganese, cobalt, nickel, chromium and iron oxides or admixtures thereof.

10. The black matrix composition of Claim 1, wherein the silica-coated metal oxide pigment or pigments are used in admixture with organic pigments, said organic pigments at levels of less than 5 wt. % of the total coating solids.

11. The black matrix composition of Claim 1, wherein the silica-coated metal oxide pigment is Pigment Black 26.

12. The black matrix composition of Claim 1, wherein the trialkoxyorganosilance coupling agents are present at about 5 wt. % based on pigment solids.

13. The black matrix composition of Claim 1, wherein the trialkoxyorganosilane coupling agent is methyl trimethoxysilane.

14. The black matrix composition of Claim 1, wherein the photoinitiator or photoinitiator system is comprised of - amine-substituted acetophenones combined with thioxanthone and octyl N, N-dimethylaminobenzoate.

15. The black matrix composition of Claim 1, wherein the solvent vehicle is a mixture of N-methyl-2-pyrrolidone (NMP) and cyclohexanone.

16. The black matrix composition of Claim 1, wherein the solvent soluble organic dye is an azo-1,2-chrome complex dye.

17. The black matrix composition of Claim 1, whereir. the solvent soluble organic dye is chosen from the group consisting of Solvent Black 27, Solvent Black 28, Solvent Black 29, and Solvent Black 45.

18. The black matrix composition of Claim 1, wherein ∼he solvent soluble organic dye is Solvent Black 28 at 1 wt. % based on pigment solids.

19. The black matrix composition of Claim 1, wherein the coating solids comprise 30-40 wt. % of the total coating composition.

20. The black matrix composition of Claim 1, wherein the alkali-soluble polymer binder makes up 5-15 wt. % of total solids, the polyfunctional acrylate or methacrylate co-monomer makes up 2-7 wt. % of total solids, the pigments make up 40-70 wt. % of total solids, the trialkoxyorganosilane makes up 1-5 wt. % of total solids, the photoinitiator makes up 10-40 wt. % of the total solids, and the solvent-soluble dyes make up 0.2 - 3.0 wt. % based on pigment loading.

21. The black matrix composition of Claim 1, wherein the alkali-soluble polymer binder makes up 8-12 wt. % of total solids, the polyfunctional acrylate or methacrylate co-monomer makes up 3-5 wt. % of total solids, the pigments make up 50-60 wt. % of total solids, the trialkoxyorganosilane makes up 3-4 wt. % of total solids, the photoinitiator makes up 20-30 wt. % of the total solids, and the solvent-soluble dyes make up 1.0 - 2.0 wt. % based on pigment loading.

22. The black matrix composition of Claim 1, wherein the level of solvent soluble organic dye is 0.2 - 3.0 wt. % based on pigment solids.

23. The black matrix composition of Claim 1, wherein the level of solvent soluble organic dye is 1.0 - 2.0 wt. % based on pigment solids.

24. A method for making a photosensitive black matrix composition having volume resistivity greater than 10⁸ohm-cm and optical density greater than 3.0 at film thicknesses of 1 µm or less as claimed in claim 1, said method comprising admixing: a binder system comprised of an alkali-soluble polymer binder and an addition photopolymerizable polyfunctional acrylate or methacrylate co-monomer or mixture of co-monomers, said co-monomer or mixtures of co-monomers having at least one ethylenically unsaturated double bond per molecule which is capable of free-radical-initiated polymerization, a silica-coated metal oxide pigment or pigments, a trialkoxyorganosilane coupling agent or admixture, a free-radical generating photoinitiator or photoinitiator system or admixture operable at less than 400 nm exposing wavelengths, a solvent vehicle alcohols, esters, glymes, ethers, glycol ether, ketones, dialkylamides, lactams, lactones and their admixtures, and a solvent soluble organic dye at levels of less than 3 wt. % based on pigment solids.

25. The method of Claim 24, wherein the alkali-soluble polymer binder is a copolymer comprising about 70 mole %. benzyl methacrylate and about 30 mole % methacrylic acid, the polyfunctional acrylate co-monomer is pentaerythritol tetraacrylate, the silica-coated metal oxide pigment is Pigment Black 26 with a primary particle size of 0.01 - 0.02 µm and at least 50 wt. % of the particles have a primary particle size smaller than 0.02 µm, the trialkoxyorganosilane coupling agent is methyl trimethoxysilane, the photoinitiator or photoinitiator system is comprised of amine-substituted acetophenones combined with thioxanthone and octyl N, N-dimethylaminobenzoate, the solvent vehicle is a mixture of N-methyl-2-pyrrolidone(NMP) and cyclohexanone, and the solvent soluble organic dye is Solvent Black 28 at 1 wt. % based on pigment solids.

## Patentansprüche

1. Photosensitive schwarze Matrix-Zusammensetzung, formuliert mit insgesamt 20-50 Gew.-% Feststoffen, in Lösung, mit einem spezifischen Volumenwiderstand größer als 10⁸ Ohm-cm und einer optischen Dichte größer als 3,0 bei einer Filmdicke von 1 µm oder weniger, aufweisend:
a. ein Bindersystem, bestehend aus:
1) einem alkalilöslichen Polymer-Binder und
2) einem photopolymerisierbaren polyfunktionellen Acrylat- oder Methacrylat-Co-Monomer oder einer Mischung aus Co-Monomeren, wobei jedes Co-Monomer eine oder mehrere ethylenisch ungesättigte Doppelbindungen je Molekül aufweist;
b. ein silikabeschichtetes Metalloxidpigment oder Pigmente mit einer primären Partikelgröße von 0,01 bis 0,02 µm, wobei wenigstens 50 Gew.-% der Partikel eine primäre Partikelteilchengröße kleiner 0,02 µm aufweisen;
c. ein Trialkoxyorganosilan-Kopplungsagens oder Beimischungen davon;
d. einen freie Radikale erzeugenden Photoinitiator oder Photoinitiatorsystem oder Beimischungen davon, gebrauchbar bei weniger als 400 nm Expositions-Wellenlängen;
e. ein Lösungsmittelvehikel, ausgewählt aus Alkoholen, Estern, Glykolethern (Glymes), Ethern, Glykolethern, Ketonen, Dialkylamiden, Lactamen, Lactonen und deren Beimischungen; und
f. einen lösungsmittellöslichen organischen Farbstoff in Mengen von weniger als 3 Gew.-% des Gewichts der dazugegebenen Pigmentfeststoffe; wobei die Zusammensetzung eine wesentlich verbesserte Gebrauchsfähigkeitsdauer im Vergleich zu anderen photoabbildbaren organischen schwarzen Matritzen mit hoher optischer Dichte und geringer Leitfähigkeit aufweist.

2. Schwarze Matrix-Zusammensetzung nach Anspruch 1, wobei der alkalilösliche Polymer-Binder ein Vinylpolymer oder ein Copolymer ist, aufweisend Acrylsäure, Methacrylsäure oder andere ethylenisch ungesättigte Monomere mit Carboxylsäure-, Sulfonsäure-, Sulfonamid-, phenolischer oder anderen sauren funktionalen Gruppen, die in der Lage sind, dem Binder eine Löslichkeit in wässrigen Basen zu verleihen.

3. Schwarze Matrix-Zusammensetzung nach Anspruch 2, wobei der alkalilösliche Polymer-Binder weiterhin ein nicht-acidisches (Meth)Acryl-Monomer enthält.

4. Schwarze Matrix-Zusammensetzung nach Anspruch 3, wobei der alkalilösliche Polymer-Binder ein Copolymer aus Methacrylsäure oder Acrylsäure und einem oder mehreren nich- acidischen (Meth)Acryl-Monomeren ist.

5. Schwarze Matrix-Zusammensetzung nach Anspruch 3, wobei der alkalilösliche Polymer-Binder ein Copolymer ist, bestehend aus ungefähr 70 Mol-% Benzyl-Methacrylat und ungefähr 30 Mol-% Methacrylsäure.

6. Schwarze Matrix-Zusammensetzung nach Anspruch 1, wobei das Co-Monomer ein polyfunktionelles (meth)acrylisches Co-Monomer oder eine Mischung aus Co-Monomeren ist mit 2 oder mehreren ethylenisch ungesättigten Doppelbindungen je Molekül.

7. Schwarze Matrix-Zusammensetzung nach Anspruch 5, wobei das Co-Monomer oder eine Mischung aus Co-Monomeren aus einem polyfunktionellen Acrylat-Monomer besteht.

8. Schwarze Matrix-Zusammensetzung nach Anspruch 6, wobei das polyfunktionelle Acrylat-Monomer Pentaerythritol-Tetraacrylat ist.

9. Schwarze Matrix-Zusammensetzung nach Anspruch 1, wobei das silikabeschichtete Metalloxidpigment oder Pigmente ausgewählt sind aus der Gruppe, bestehend aus Kupfer-, Mangan-, Kobalt-, Nickel-, Chrom- und Eisenoxiden oder Beimischungen davon.

10. Schwarze Matrix-Zusammensetzung nach Anspruch 1, wobei das silikabeschichtete Metalloxidpigment oder Pigmente verwendet werden in Beimischungen mit organischen Pigmenten, wobei die organischen Pigmente in Mengen von weniger als 5 Gew.-% der gesamten Beschichtungsfeststoffe vorliegen.

11. Schwarze Matrix-Zusammensetzung nach Anspruch 1, wobei das silikabeschichtete Metalloxidpigment das Pigment Black 26 ist.

12. Schwarze Matrix-Zusammensetzung nach Anspruch 1, wobei die Trialkoxyorganosilan-Kopplungsagentien in Mengen von ungefähr 5 Gew.-%, basierend auf Pigmentfeststoffen, vorliegen.

13. Schwarze Matrix-Zusammensetzung nach Anspruch 1, wobei das Trialkoxyorganosilan-Kopplungsagens Methyltrimethoxysilan ist.

14. Schwarze Matrix-Zusammensetzung nach Anspruch 1, wobei der Photoinitiator oder das Photoinitiatorsystem besteht aus aminsubstituierten Acetophenonen kombiniert mit Thioxanthon und Octyl-N, N-Dimethylaminbenzoat.

15. Schwarze Matrix-Zusammensetzung nach Anspruch 1, wobei das Lösungsmittelvehikel eine Mischung aus N-Methyl-2-Pyrrolidon (NMP) und Cyclohexanon ist.

16. Schwarze Matrix-Zusammensetzung nach Anspruch 1, wobei der lösungsmittellösliche organische Farbstoff ein Azo-1,2-Chrom-Komplex-Farbstoff ist.

17. Schwarze Matrix-Zusammensetzung nach Anspruch 1, wobei der lösungsmittellösliche organische Farbstoff ausgewählt ist aus der Gruppe, bestehend aus Solvent Black 27, Solvent Black 28, Solvent Black 29 und Solvent Black 45.

18. Schwarze Matrix-Zusammensetzung nach Anspruch 1, wobei der lösungsmittellösliche organische Farbstoff Solvent Black 28 mit 1 Gew.-%, basierend auf Pigmentfeststoffen, ist.

19. Schwarze Matrix-Zusammensetzung nach Anspruch 1, wobei die Beschichtungsfeststoffe 30-40 Gew.-% der gesamten Beschichtungszusammensetzung ausmachen.

20. Schwarze Matrix-Zusammensetzung nach Anspruch 1, wobei der alkalilösliche Polymer-Binder 5 bis 15 Gew.-% an gesamten Feststoffen ausmacht, das polyfunktionale Acrylat- oder Methacrylat-Co-Monomer 2-7 Gew.-% der gesamten Feststoffe ausmacht, die Pigmente 40-70 Gew.-% der gesamten Feststoffe ausmachen, das Trialkoxyorganosilan 1-5 Gew.-% der gesamten Feststoffe ausmacht, der Photoinitiator 10-40 Gew.-% der gesamten Feststoffe ausmacht und der lösungsmittellösliche Farbstoff 0,2-3,0 Gew.-%, basierend auf der Pigmentbeladung, ausmacht.

21. Schwarze Matrix-Zusammensetzung nach Anspruch 1, wobei der alkalilösliche Polymer-Binder 8-12 Gew.-% der gesamten Feststoffe ausmacht, das polyfunktionale Acrylat- oder Methacrylat-Co-Monomer 3-5 Gew.-% der gesamten Feststoffe ausmacht, die Pigmente 50-60 Gew.-% der gesamten Feststoffe ausmachen, das Trialkoxyorganosilan 3-4 Gew.-% der gesamten Feststoffe ausmacht, der Photoinitiator 20-30 Gew.-% der gesamten Feststoffe ausmacht und die lösungsmittellöslichen Farbstoffe 1,0-2,0 Gew.-%, basierend auf der Pigmentbeladung, ausmachen.

22. Schwarze Matrix-Zusammensetzung nach Anspruch 1, wobei der Gehalt an lösungsmittellöslichem organischen Farbstoff 0,2-3,0 Gew.-%, basierend auf Pigmentfeststoffen, beträgt.

23. Schwarze Matrix-Zusammensetzung nach Anspruch 1, wobei der Gehalt an lösungsmittellöslichem organischen Farbstoff 1,0-2,0 Gew.-%, basierend auf Pigmentfeststoffen, beträgt.

24. Verfahren zur Herstellung einer photosensitiven schwarzen Matrix-Zusammensetzung mit einem spezifischen Volumenwiderstand größer als 10⁸ ohm-cm und einer optischen Dichte größer 3,0 bei einer Filmdicke von 1 µm oder weniger, wie in Anspruch 1 beansprucht, wobei das Verfahren das Beimischen beinhaltet von:
einem Bindersystem, bestehend aus einem alkalilöslichen Polymer-Binder und einem Additionsphotopolymerisierbaren polyfunktionellen Acrylat- oder Methacrylat-Co-Monomer oder Mischung aus Co-Monomeren, wobei das Co-Monomer oder Mischungen aus Co-Monomeren wenigstens eine ethylenisch ungesättigte Doppelbindung je Molekül aufweist, die für eine freie Radikale initiierte Polymerisation fähig ist, einem silikabeschichteten Metalloxidpigment oder Pigmenten, einem Trialkoxyorganosilan-Kopplungsagens oder -beimischung, einem freie Radikale erzeugendenden Photoinitiator oder Photointiatorsystem oder -beimischung, die wirksam ist bei weniger als 400 nm Expositionswellenlängen, einem Lösungsmittelvehikel ausgewählt aus Alkoholen, Estern, Glykolethern (Glymes), Ethern, Glykolethern, Ketonen, Dialkylamiden, Lactamen, Lactonen und deren Beimischungen, und einem lösungsmittellöslichen organischen Farbstoff bei Mengen von weniger als 3 Gew.-%, basierend auf Pigmentfeststoffen.

25. Verfahren nach Anspruch 24, wobei der alkalilösliche Polymer-Binder ein Co-Polymer ist, bestehend aus ungefähr 70 Mol-% Benzyl-Methacrylat und ungefähr 30 Mol-% Methacrylsäure, wobei das polyfunktionelle Acrylat-Co-Monomer Pentaerythritol-Tetraacrylat ist, das silikabeschichtete Metalloxidpigment Pigment Black 26 mit einer Primärpartikelgröße von 0,01-0,02 µm ist und wenigstens 50 Gew.-% der Partikel eine Primärpartikelgröße kleiner als 0,02 µm aufweisen, wobei das Trialkoxyorganosilan-Kopplungs-Agens Methyltrimethoxysilan ist, wobei der Photoinitiator oder das Photoinitiatorsystem besteht aus amin-substituierten Acetophenonen kombiniert mit Thioxanthon und Octyl-N, N-Dimethylaminbenzoat, wobei das Lösungsmittelvehikel eine Mischung aus N-Methyl-2-Pyrrolidon (NMP) und Cyclohexanon ist, und der lösungsmittellösliche organische Farbstoff Solvent Black 28 bei 1 Gew.-%, basierend auf Pigment-Feststoffen, ist.

## Revendications

1. Composition de matrice noire photosensible formulée de 20 à 50 % en poids de solides totaux, en solution, ayant une résistivité de volume supérieure à 10⁸ ohm-cm et une densité optique supérieure à 3,0 à des épaisseurs de film de 1 µm ou inférieur, comprenant :
a. un système liant constitué de :
1) un liant polymère soluble dans les alcali et
2) un acrylate polyfonctionnel photopolymérisable ou un co-monomère ou un mélange de co-monomères de méthacrylate, chaque co-monomère ayant une ou plusieurs doubles liaisons à insaturation éthylénique par molécule ;
b. un ou des pigments d'oxyde métallique revêtu de silice ayant une taille de particule primaire de 0,01 à 0,02 µm, à au moins 50 % en poids des particules ayant une taille de particule primaire inférieure à 0,02 ;
c. un agent de couplage trialcoxyorganosilane ou leurs mélanges ;
d. un photoinitiateur ou un système photoinitiateur produisant un radical libre ou leurs mélanges, opérable à moins de 400 nm de longueurs d'onde d'exposition ;
e. un solvant véhicule choisi parmi les alcools, les esters, les glymes, les éthers, un glycol éther, les cétones, les dialkylamides, les lactames, les lactones et leurs mélanges ; et
f. un colorant organique soluble dans un solvant à des niveaux inférieurs à 3 % en poids du poids des solides de pigment ajoutés ; moyennant quoi la composition a une durée de conservation essentiellement améliorée par rapport aux autres matrices noires organiques photoimageables ayant une densité optique élevée et une conductivité faible.

2. Composition de matrice noire selon la revendication 1, dans laquelle le liant polymère soluble dans les alcali est un polymère ou un copolymère de vinyle contenant de l'acide acrylique, de l'aide méthacrylique, ou d'autres monomères à insaturation éthylénique ayant un acide carboxylique, un acide sulfonique, un sulfonamide, un phénolique ou d'autres groupes fonctionnels acides capables de conférer une solubilité dans les bases aqueuses au liant.

3. Composition de matrice noire selon la revendication 2, dans laquelle le liant polymère soluble dans les alcali contient en outre un monomère (méth)acrylique non acide.

4. Composition de matrice noire selon la revendication 3, dans laquelle le liant polymère soluble dans les alcali est un copolymère d'acide méthacrylique ou d'acide acrylique et d'un ou plusieurs monomères (méth)acryliques non acides.

5. Composition de matrice noire selon la revendication 3, dans laquelle le liant polymère soluble dans les alcali est un copolymère comprenant environ 70 % en moles de benzyl méthacrylate et environ 30 % en moles d'acide méthacrylique.

6. Composition de matrice noire selon la revendication 1, dans laquelle le co-monomère est un co-monomère (méth)acrylique polyfonctionnel ou un mélange de co-monomères ayant deux ou plus de deux doubles liaisons insaturées par molécule.

7. Composition de matrice noire selon la revendication 5, dans laquelle le co-monomère ou le mélange de co-monomères est constitué d'un monomère acrylate polyfonctionnel.

8. Composition de matrice noire selon la revendication 6, dans laquelle le monomère acrylate polyfonctionnel est le pentaérythritol tétraacrylate.

9. Composition de matrice noire selon la revendication 1, dans laquelle le ou les pigments d'oxyde métallique revêtus de silice sont choisis dans le groupe comprenant les oxydes de cuivre, de manganèse, de cobalt, de nickel, de chrome et de fer ou leurs mélanges.

10. Composition de matrice noire selon la revendication 1, dans laquelle le ou les pigments d'oxyde métallique revêtus de silice sont utilisés en mélange avec des pigments organiques, lesdits pigments organiques à des niveaux inférieurs à 5 % en poids des solides de revêtement totaux.

11. Composition de matrice noire selon la revendication 1, dans laquelle le pigment d'oxyde métallique revêtu de silice est le pigment noir 26.

12. Composition de matrice noire selon la revendication 1, dans laquelle les agents de couplage trialcoxyorganosilane sont présents à environ 5 % en poids basé sur les solides de pigment.

13. Composition de matrice noire selon la revendication 1, dans laquelle l'agent de couplage trialkylorganosilane est le méthyl triméthoxysilane.

14. Composition de matrice noire selon la revendication 1, dans laquelle le photoinitiateur ou le système de photoinitiateur comprend les acétophénones aminosubstituées combinées avec la thioxanthone et l'octyl N,N-diméthylaminobenzoate.

15. Composition de matrice noire selon la revendication 1, dans laquelle le solvant véhicule est un mélange de N-méthyl-2-pyrrolidone (NMP) et de cyclohexanone.

16. Composition de matrice noire selon la revendication 1, dans laquelle le colorant organique soluble dans un solvant est un colorant complexe azo-1,2-chrome.

17. Composition de matrice noire selon la revendication 1, dans laquelle le colorant organique soluble dans un solvant est choisi dans le groupe comprenant le solvant noir 27, le solvant noir 28, le solvant noir 29, et le solvant noir 45.

18. Composition de matrice noire selon la revendication 1, dans laquelle le colorant organique soluble dans un solvant est le solvant noir 28 à 1 % en poids basé sur les solides de pigment.

19. Composition de matrice noire selon la revendication 1, dans laquelle les solides de revêtement comprennent 30 à 40 % en poids de la composition de revêtement totale.

20. Composition de matrice noire selon la revendication 1, dans laquelle le liant polymère soluble dans les alcali constitue de 5 à 15 % en poids des solides totaux, le co-monomère acrylate ou méthacylate polyfonctionnel constitue de 2 à 7 % en poids des solides totaux, les pigments constituent de 40 à 70 % en poids des solides totaux, le trialcoxyorganosilane constitue de 1 à 5 % en poids des solides totaux, le photoinitiateur constitue de 10 à 40 % en poids des solides totaux, et les colorants solubles dans un solvant constituent de 0,2 à 3,0 % en poids basés sur la charge de pigment.

21. Composition de matrice noire selon la revendication 1, dans laquelle le liant polymère soluble dans les alcali constitue de 8 à 12 % en poids des solides totaux, le co-monomère acrylate ou méthacylate polyfonctionnel constitue de 3 à 5 % en poids des solides totaux, les pigments constituent de 50 à 60 % en poids des solides totaux, le trialcoxyorganosilane constitue de 3 à 4 % en poids des solides totaux, le photoinitiateur constitue de 20 à 30 % en poids des solides totaux, et les colorants solubles dans un solvant constituent de 1,0 à 2,0 % en poids basés sur la charge de pigment.

22. Composition de matrice noire selon la revendication 1, dans laquelle le niveau de colorant organique soluble dans un solvant est de 0,2 à 3,0 % en poids basé sur les pigments solides.

23. Composition de matrice noire selon la revendication 1, dans laquelle le niveau de colorant organique soluble dans un solvant est de 1,0 à 2,0 % en poids basé sur les pigments solides.

24. Procédé pour fabriquer une composition de matrice noire photosensible ayant une résistivité de volume supérieure à 10⁸ ohm-cm et une densité optique supérieure à 3,0 à des épaisseurs de film de 1 µm ou inférieur selon la revendication 1, ledit procédé comprenant le mélange de : un système liant comprenant un liant polymère soluble dans les alcali et un co-monomère ou un mélange de co-monomères d'acrylate ou de méthacrylate polyfonctionnels photopolymérisables, lesdits co-monomère ou mélange de co-monomères ayant au moins une double liaison à insaturation éthylénique par molécule qui est capable de polymérisation initiée par un radical libre, un ou des pigments d'oxyde métallique revêtus de silice, un agent de couplage trialcoxyorganosilane ou un mélange, un photoinitiateur ou un système de photoinitiateur ou un mélange produisant un radical libre opérable à moins de 400 nm de longueurs d'onde d'exposition, un solvant véhicule d'alcools, esters, glymes, éthers, glycol éther, cétones, dialkylamides, lactames, lactones et leurs mélanges, et un colorant organique soluble dans un solvant à des niveaux inférieurs à 3 % en poids basés sur les pigments solides.

25. Procédé selon la revendication 24, dans lequel le liant polymère soluble dans les alcali est un copolymère comprenant 70 % en moles de benzyl méthacrylate et environ 30 % en moles d'acide méthacrylique, le co-monomère acrylate polyfonctionnel est le pentaérythritol tétraacrylate, le pigment d'oxyde métallique revêtu de silice est le pigment noir 26 avec une taille de particule primaire de 0,01 à 0,02 µm et au moins 50 % en poids des particules ont une taille de particule primaire inférieure à 0,02 µm, l'agent de couplage trialcoxyorganosilane est le méthyl triméthoxysilane, le photoinitiateur ou le système de photoinitiateur comprend les acétophénones amino-substituées combinées avec la thioxanthone et l'octyl N,N-diméthylaminobenzoate, le véhicule solvant est un mélange de N-méthyl-2-pyrrolidone (NMP) et de cyclohexanone, et le colorant organique soluble dans un solvant est le solvant noir 28 à 1 % en poids basé sur les solides de pigment.
